Europäisches Patentamt

European Patent Office

Office européen des brevets

(11) Publication number : **0 332 356 B1**

# (12) EUROPEAN PATENT SPECIFICATION

(45) Date of publication of patent specification :
05.05.93 Bulletin 93/18

(21) Application number : **89302176.6**

(22) Date of filing : **03.03.89**

(51) Int. Cl.⁵ : **F17C 7/02, B08B 7/00, B01D 46/00, // H01L21/306, H01L21/465**

(54) **Supply of carbon dioxide.**

(30) Priority : **05.03.88 JP 51870/88**

(43) Date of publication of application :
**13.09.89 Bulletin 89/37**

(45) Publication of the grant of the patent :
**05.05.93 Bulletin 93/18**

(84) Designated Contracting States :
**BE CH DE FR GB IT LI LU NL**

(56) References cited :
**DE-A- 2 539 499
DE-A- 3 804 694
COMPRESSED AIR MAGAZINE, August 1986,
pages 22-25; S.A. HOENIG:
"Cleaningsurfaces with dry ice"**

(56) References cited :
**PATENT ABSTRACTS OF JAPAN, vol. 11, no.
360 (M-645)[2807], 25th November 1987; &
JP-A-62 136 372 (HONDA MOTOR CO. LTD)
19-06-1987
PATENT ABSTRACTS OF JAPAN, vol. 10, no. 1
(E-371)[2058], 7th January 1986; & JP-A-60 165
726 (ORGANO K.K.) 28-08-1985**

(73) Proprietor : **OSAKA SANSO KOGYO LIMITED
Sumitomo Seimei Shin-Osaka Kita Building
1-14 Miyahara 4-Chome
Yodogawa-Ku Osaka 532 (JP)**

(72) Inventor : **Kozo, Moriya
101,13, Shinkoriyama 2-chome
Ibaragi-shi Osaka prefecture (JP)**
Inventor : **Ohkatsu, Tadashi
405-504, 1, Nakaochiai 1-chome Suma-ku
Kobe-shi Hyogo Prefecture (JP)**

(74) Representative : **Wickham, Michael
c/o Patent and Trademark Department The
BOC Group plc Chertsey Road
Windlesham Surrey GU20 6HJ (GB)**

## Description

The present invention relates to a method of supplying liquefied $CO_2$ containing a reduced number of particles and also pertains to a method of removing particles or oil or the like from the surface of an object or substrate to be cleaned by the said liquefied $CO_2$.

Liquefied $CO_2$ has excellent properties as a solvent and is known to be capable of readily removing particles, oil and other contaminants from an article or substrate to be cleaned. In the semiconductor industry, there is a particular need to remove substantially completely particles adhering in trace amounts to the surface of a wafer of semi-conducting material.

The present inventors have found that a large number of particles are contained in commercially available 5 nine (N) high-purity liquefied $CO_2$ (ie liquid carbon dioxide of 99.999% purity), as shown in Table 1 below.

Table 1:
Particles contained in commercially available 5 N liquefied $CO_2$

| | Numbers of particles ($0.3\mu$ or greater) particles/cF |
|---|---|
| Commercially available 5 N liquefied $CO_2$ | $10^8$ |

If a wafer or the like is cleaned with dry ice snow obtained from such $CO_2$, particles are removed from the surface of the object of cleaning but, at the same time, particles contained in the dry ice snow are attached thereto instead. For this reason, use commercially available high purity liquefied $CO_2$ has been generally unsuccessful in cleaning such wafers.

It has been the general practice to remove particles from liquefied $CO_2$ by means of a filter. Table 2 below shows the results of an experiment in which liquefied $CO_2$ was passed through a filter in the liquid state. As will be clear from Table 2, substantially no particles can be removed from liquefied $CO_2$ by means of a filter.

Table 2:

| | Numbers of particles ($0.3\mu$ or greater) particles/cF |
|---|---|
| Before passage through filter | $10^8$ |
| After passage through filter | $10^7$ |

According to the invention there is provided a method of supplying liquefied $CO_2$ comprising the steps of:
(a) vaporising liquefied $CO_2$;
(b) passing a stream of the resulting $CO_2$ gas through a filter to remove particles therefrom;
(c) reliquefying the said stream of $CO_2$ gas by cooling; and
(d) passing the reliquefied stream to a location where it is to be used.

The reliquefied stream may be used to clean a substrate such as a 'wafer' for use in electronics.

Using the method according to the invention, the results set out in Table 3 below have been achieved.

Table 3:

| | Numbers of particles (0.3μ or greater) particles/cF |
|---|---|
| Before passage through LCO$_2$ filter | $10^8$ |
| After passage through GCO$_2$ filter | 0 |

The invention will now be described by way of example with reference to the accompanying drawing which shows a preferred form of an apparatus for carrying out the method according to the present invention.

A stream of liquefied $CO_2$ (containing 99.999% by volume of $CO_2$) is supplied from a storage tank 1. The stream is passed through an evaporator 2 where it is changed into a stream of $CO_2$ gas which is then passed through a filter 3 where particles are removed therefrom. Thereafter, the $CO_2$ gas is reliquefied in a liquefier 4 and this reliquefied $CO_2$ gas is passed successively through a needle valve 5 and a filter 6 and then jetted out from a nozzle 7 in the form of fine dry ice snow. This dry ice snow may be blown over an object or substrate for cleaning, such as a wafer, to remove particles from the surface of the object or substrate.

The piping, valve and nozzle which are installed on the downstream side of the filter 3 comprise electro or chemically polished pipe having a smooth and clean inner surface with a view to suppressing contamination of the gas with particles trapped in or between surfaces that are not suitably smooth.

A commercially available $CO_2$ container (for either $CO_2$ gas or liquefied $CO_2$) may be used in place of the $CO_2$ tank 1.

Examples of objects which may be effectively cleaned by the method according to the present invention include wafers, compact disks, laser disks, lenses, and so on.

Generally speaking, when liquefied $CO_2$ is blown over the surface of an object of cleaning, such as a wafer, it is rapidly cooled by the object and thus condensed on the surface thereof, resulting in the object being wet with dew. It will take some time to dry such a wet object and there is also a possibility that the surface of the object will be contaminated by the water attached thereto. In order to avoid these problems, the substrate to be cleaned may be in position in a room or chamber filled with a $N_2$ atmosphere when liquefied $CO_2$ is blown over it. The object or substrate to be cleaned may be heated with an electric heater when liquefied $CO_2$ is blown over it. Both of two means may be adopted simultaneously.

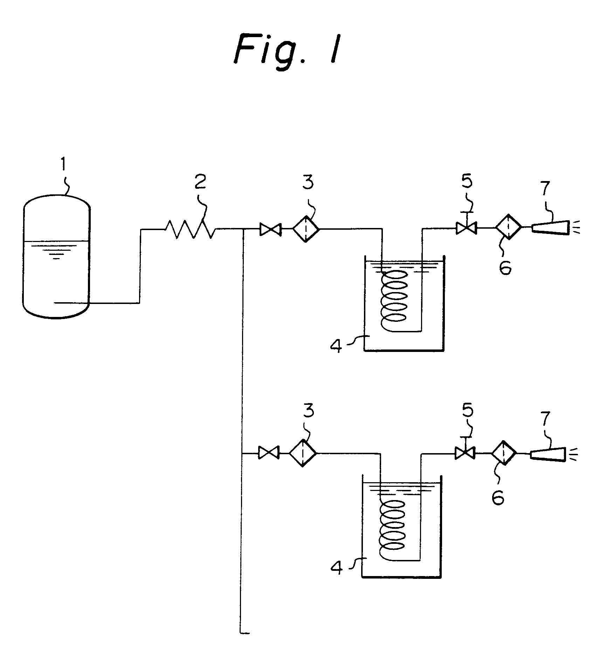

It is to be appreciated that conventional $CO_2$ storage tanks tend to be sources of particulate contamination. It is not practical to clean the inner surfaces of the $CO_2$ storage tank by a electropolishing method, which would be necessarily complicated, and then to wash them with ultrapure water since such a procedure adds substantially to the production cost of the container. Instead, as shown in Figure 1, the liquefier 4 may be set up on the wafer (or other substrate) cleaning site and liquefied $CO_2$ is directly supplied from the liquefier, and this approach is inexpensive and hence practical. The liquefier 4 can be readily fabricated of an electropolished tube. The present invention thus provides an inexpensive method for on-site supply of liquefied $CO_2$ whose particle content is sufficiently low to justify its use in the cleaning of chip wafers and other products that require utmost cleanliness.

## Claims

1. A method of supplying liquefied $CO_2$ comprising the steps of:
   (a) vaporising liquefied $CO_2$;
   (b) passing a stream of the resulting $CO_2$ gas through a filter to remove particles therefrom;
   (c) reliquefying the said stream of $CO_2$ gas by cooling; and
   (d) passing the reliquefied stream to a location where it is to be used.

2. A method according to claim 1, in which the reliquefied stream issued to clean a substrate.

3. A method according to claim 2, wherein the stream of reliquefied $CO_2$ is passed out of a nozzle in the form of a jet so as to blow $CO_2$ gas and/or liquefied $CO_2$ containing dry ice snow over the surface of the substrate.

4. A method according to claim 3, wherein the substrate is held in a nitrogen atmosphere.

5. A method according to claim 3 or claim 4, wherein the substrate is heated.

6. A method of supplying liquefied $CO_2$, inlcuding filtering a stream of gaseous carbon dioxide to remove particles therefrom, liquefying the filtered stream, and passing the resulting liquefied stream to a location where is to be used.

7. A method according to claim 6, in which the liquefied stream is used to clean a surface of a substrate.


**Patentansprüche**

1. Verfahren zur Zuführung von verflüssigtem $CO_2$, das folgende Schritte umfaßt:
   (a) Verdampfung von verflüssigtem $CO_2$;
   (b) Durchführung eines Stromes des resultierenden $CO_2$-Gases durch ein Filter, um daraus Partikel zu beseitigen;
   (c) Wiederverflüssigung des $CO_2$-Gasstromes durch Kühlung; und
   (d) Zuführung des wiederverflüssigten Stromes an eine Stelle, an welcher er verwendet wird.

2. Verfahren nach Anspruch 1, in welchem der wiederverflüssigte Strom ausströmt, um ein Substrat zu reinigen.

3. Verfahren nach Anspruch 2, worin der Strom des wiederverflüssigten $CO_2$ aus einer Düse in Form eines Strahles geführt wird, um $CO_2$-Gas und/oder verflüssigtes $CO_2$, das Trockeneisschnee enthält, über die Oberfläche des Substrates zu blasen.

4. Verfahren nach Anspruch 3, worin das Substrat in einer Stickstoffatmosphäre gehalten wird.

5. Verfahren nach Anspruch 3 oder 4, worin das Substrat erwärmt wird.

6. Vefahren zur Zuführung von verflüssigtem $CO_2$, welches die Filterung eines gasförmigen Kohlendioxidstromes, um daraus Partikel zu beseitigen, die Verflüssigung des gefilterten Stromes und die Zuführung des resultierenden verflüssigten Stromes an eine Stelle, an welcher er verwendet wird, umfaßt.

7. Verfahren nach Anspruch 6, in welchem der verflüssigte Strom benutzt wird, um eine Substratoberfläche zu reinigen.


**Revendications**

1. Procédé d'alimentation en $CO_2$ liquéfié comprenant les étapes suivantes :
   (a) vaporisation du $CO_2$ liquéfié ;
   (b) passage d'un courant du $CO_2$ gazeux obtenu dans un filtre pour en éliminer les particules ;
   (c) reliquéfaction dudit courant de $CO_2$ gazeux par refroidissement; et
   (d) envoi du courant reliquéfié vers le lieu où il doit être utilisé.

2. Procédé selon la Revendication 1, dans lequel le courant reliquéfié est émis pour nettoyer un substrat.

3. Procédé selon la Revendication 2, dans lequel le courant de $CO_2$ reliquéfié traverse et ressort d'un diffuseur sous forme d'un jet afin de souffler du $CO_2$ gazeux et/ou du $CO_2$ liquéfié contenant de la neige carbonique sur la surface du substrat.

4. Procédé selon la Revendication 3, dans lequel le substrat est maintenu sous atmosphère d'azote.

5. Procédé selon la Revendication 3 ou 4, dans lequel le substrat est chauffé.

6. Procédé d'alimentation en $CO_2$ liquéfié comprenant la filtration d'un courant de dioxyde de carbone gazeux pour en éliminer les particules, la liquéfaction du courant filtré, et l'envoi du courant liquéfié obtenu vers un emplacement où il doit être utilisé.

7. Procédé selon la Revendication 6, dans lequel le courant liquéfié est utilisé pour nettoyer une surface d'un substrat.

# Fig. I